# FASCICULE DE BREVET EUROPEEN

(11) **EP 1 992 069 B1**
(45) Date de publication et mention de la délivrance du brevet: **31.03.2010**
(21) Numéro de dépôt: 06847182.0
(22) Date de dépôt: 19.12.2006
(51) Int. Cl.: H03K 17/082, H03K 17/16

(54) **DISPOSITIF DE COMMANDE D'UN TRANSISTOR MOS**
EINRICHTUNG ZUR STEUERUNG EINES MOS-TRANSISTORS
DEVICE FOR CONTROLLING A MOS TRANSISTOR

(30) Priorité: 23.01.2006 FR 0600572
(43) Date de publication de la demande: 19.11.2008
(73) Titulaire: VALEO EQUIPEMENTS ELECTRIQUES MOTEUR, 94046 Créteil Cedex (FR)
(72) Inventeur: DOFFIN, Hugues, F-94046 Creteil (FR)
(86) Numéro de dépôt international: PCT/FR2006/051392
(87) Numéro de publication internationale: WO 2007/083008

(56) Documents cités:
- US-A- 5 408 150
- US-A1- 2001 030 880
- US-A1- 2004 085 117
- US-B1- 6 222 751

## Description

### Domaine de l'invention

La présente invention concerne un dispositif de commande d'un transistor MOS (MOSFET).

Un tel dispositif de commande est par exemple mis en oeuvre dans le cadre d'une machine électrique tournante, par exemple un alternateur ou alterno-démarreur.

Un alterno-démarreur comporte de manière classique :
- un rotor représentant un inducteur dans lequel est amené un courant d'excitation, et
- un stator polyphasé représentant un induit et comportant plusieurs phases.

L'alterno-démarreur fonctionne en mode moteur ou en mode générateur. C'est une machine dite réversible.

En mode générateur appelé également mode alternateur, la machine permet de transformer un mouvement de rotation du rotor entraîné par le moteur thermique du véhicule, en un courant électrique induit dans les phases du stator. Dans ce cas, un pont redresseur relié aux phases du stator permet de redresser le courant induit sinusoïdal en un courant continu pour alimenter des consommateurs du véhicule tels qu'une batterie. Un tel pont comporte un bras par phase, un bras comprenant deux transistors MOSFET en général.

Au contraire, en mode moteur, la machine électrique fait office de moteur électrique permettant d'entraîner en rotation, via l'arbre du rotor, le moteur thermique du véhicule. Il permet de transformer l'énergie électrique en énergie mécanique. Dans ce cas, l'unité de puissance forme un onduleur permettant de transformer un courant continu en un courant alternatif qui permet de générer un couple moteur.

### Etat de la technique

Dans le document intitulé « New Gate Control Unit for Automotive Synchronous Rectifiers », auteurs stephan Rees et Ulrich Ammann édité par l' »Institute of Power Electronics and Control Engineering, University of Stuttgart » est représenté un dispositif de commande permettant de commander de façon adéquate les transistors du pont redresseur pour redresser correctement le courant induit sinusoïdal.
Un dispositif de commande est relié à chaque transistor du pont redresseur/onduleur. Le dispositif de commande comporte un amplificateur opérationnel permettant de commander le transistor associé.
Un des inconvénients de ce dispositif est qu'il est soumis aux courants de fuite provenant de la batterie.
De ce fait, les transistors du pont redresseur/onduleur peuvent être endommagés en raison de ces courants de fuite et lorsque le véhicule est à l'arrêt, le pont redresseur/onduleur consomme en permanence du courant ce qui peut décharger la batterie.

Le document US-2001/030880 divulgue aussi l'état de la technique.

### Exposé de l'invention

La présente invention a notamment pour but de pallier ces inconvénients.

L'invention propose un dispositif de commande d'un transistor qui permet de limiter les courants de fuite de manière à ce que le transistor fonctionne correctement et à ce que la batterie ne se décharge pas lorsque le véhicule est à l'arrêt.

L'invention propose ainsi un dispositif de commande d'un transistor formé d'un canal comprenant une grille, un source, et un drain, ledit dispositif comportant un dispositif d'amplification pour contrôler la grille du transistor via un signal de commande de sortie, ledit dispositif comprenant une première entrée reliée au drain du transistor, le tout formant une première liaison, une deuxième entrée reliée à la source du transistor, le tout formant une deuxième liaison.

Conformément à l'invention, le dispositif de commande comporte également :
- au moins un dispositif de protection comprenant au moins un élément de commutation qui est inséré en série dans ladite première liaison du dispositif d'amplification pour empêcher le passage d'un courant de fuite à travers ladite première liaison, et
- un dispositif de génération d'une tension de régulation pour commander le transistor, ledit dispositif de génération étant configuré de sorte qu'il existe un même nombre N de jonctions semiconductrices entre la première et la deuxième liaisons.

Ainsi, ce dispositif de protection va bloquer les courants de fuite de sorte que aucun courant de fuite ne puisse s'échapper de la batterie et aller dans ledit dispositif. De cette manière, lorsque le véhicule est à l'arrêt, la batterie ne risque pas de se décharger et le pont redresseur/onduleur ne consomme rien.

Selon des modes de réalisation non limitatifs, le dispositif selon l'invention peut comporter une ou plusieurs des caractéristiques suivantes :
- Le dispositif de commande d'un transistor comporte en outre une boucle de rétroaction de la sortie vers une des entrées.
- Le dispositif de commande d'un transistor comporte en outre un dispositif de protection couplé à la boucle de rétroaction.
- Le dispositif de protection comporte une diode.
- Le dispositif de protection comporte un interrupteur.
- Le dispositif de protection est associé à une source d'alimentation destinée à polariser ledit dispositif de protection par un courant.
- La première entrée du dispositif d'amplification est l'entrée négative et la deuxième entrée est l'entrée positive.
- Le dispositif de commande est réalisé dans un circuit intégré comprenant ou non ledit transistor.
- La (les) jonction(s) sur la première liaison est de même nature que celle(s) sur la deuxième liaison.
- Le nombre de jonctions N est égal à 0.
- Le nombre de jonctions N est égal à 1.
- Le dispositif de génération de la tension de régulation intègre le dispositif de protection.

L'invention propose également un système de gestion de deux batteries pour véhicule automobile, comportant un premier et un deuxième dispositifs de commande respectivement d'un premier et deuxième transistors, lesdits dispositifs étant destinés à mettre en parallèle les batteries, le premier dispositif de commande étant caractérisé selon l'une des caractéristiques précédentes.

Le deuxième dispositif de commande comporte une commande du deuxième transistor en tout ou rien.

L'invention propose également un pont de puissance pour machine électrique tournante polyphasée comprenant au moins un bras de pont composé de transistors, le bras de pont étant associé à une phase de la machine, et un dispositif de commande par transistor selon l'une des caractéristiques précédentes.

L'invention propose également une machine électrique tournante comprenant un système de gestion de deux batteries selon l'une des caractéristiques précédentes.

L'invention propose également une machine électrique tournante comprenant un pont de puissance selon l'une des caractéristiques précédentes.

### Brève description des dessins

D'autres particularités et avantages de la présente invention apparaîtront dans la description ci-après d'exemples de réalisation non limitatifs, en référence aux dessins annexés, dans lesquels :
- la Fig. 1 est un premier schéma d'un exemple de circuit dans lequel un dispositif conforme à l'invention peut être utilisé dans le cadre d'une première application;
- la Fig. 2 est un premier schéma fonctionnel du dispositif de commande conforme à l'invention;
- la Fig. 3 est un premier exemple de réalisation d'un dispositif de protection compris dans le dispositif de commande de la Fig. 2;
- la Fig. 4 est un deuxième exemple de réalisation d'un dispositif de protection compris dans le dispositif de commande de la Fig. 2;
- la Fig. 5 est une variante du deuxième exemple de réalisation d'un dispositif de protection compris dans le dispositif de commande de la Fig. 2;
- la Fig. 6 est un troisième exemple de réalisation d'un dispositif de protection compris dans le dispositif de commande de la Fig. 2;
- la Fig. 7 est un deuxième schéma fonctionnel du dispositif de commande conforme à l'invention;
- la Fig. 8 est un premier exemple de réalisation d'un dispositif de protection compris dans le dispositif de commande de la Fig. 7;
- la Fig. 9 est un deuxième exemple de réalisation d'un dispositif de protection compris dans le dispositif de commande de la Fig. 7;
- la Fig. 10 est un troisième schéma fonctionnel du dispositif de commande conforme à l'invention; et
- la Fig. 11 est un deuxième schéma d'un exemple de circuit dans lequel un dispositif conforme à l'invention peut être utilisé dans le cadre d'une deuxième application.

### Description détaillée de modes de réalisation de l'invention

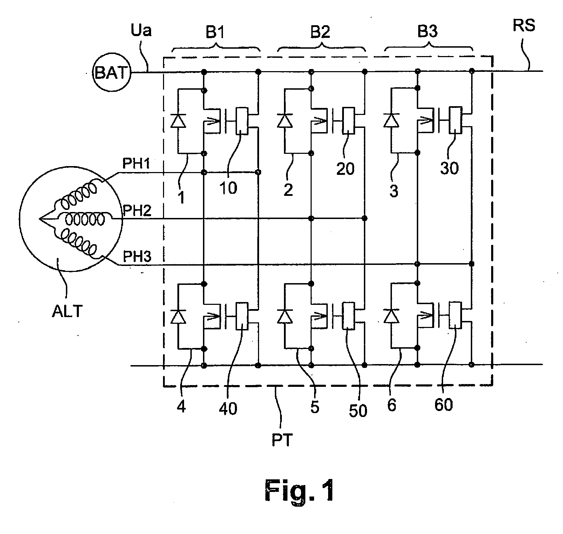

Le dispositif de commande 10 d'un transistor peut être mis en oeuvre dans un pont redresseur d'un alterno-démarreur tel qu'illustré à la Fig. 1.

Dans la suite de la description, il est décrit dans le cadre de cette application. Bien entendu, ladite application n'est qu'un exemple d'application non limitatif pour ledit dispositif de commande 10. Ledit dispositif peut être utilisé dans d'autres applications comme on le verra en détail plus loin.

Sur la Fig. 1 est représenté un pont de puissance PT relié à un alterno-démarreur ALT et à un réseau de bord RS de véhicule automobile et à une batterie BAT qui alimente ledit pont redresseur via une tension Ua. Le pont de puissance PT comprend trois bras B1, B2 et B3, chaque bras étant composé de deux transistors 1 à 6 et étant relié à une phase PH1, PH2, PH3 du stator de l'alterno-démarreu r.

Un dispositif de commande 10 à 60 est associé à chacun des transistors du pont de puissance PT pour faire commuter lesdits transistors de manière à obtenir soit le redressement du courant alternatif (fonction pont redresseur), soit pour obtenir un couple mécanique moteur (fonction onduleur).

Dans la suite de la description un seul dispositif de commande est décrit, tous les dispositifs du pont de puissance étant identiques dans cet exemple.

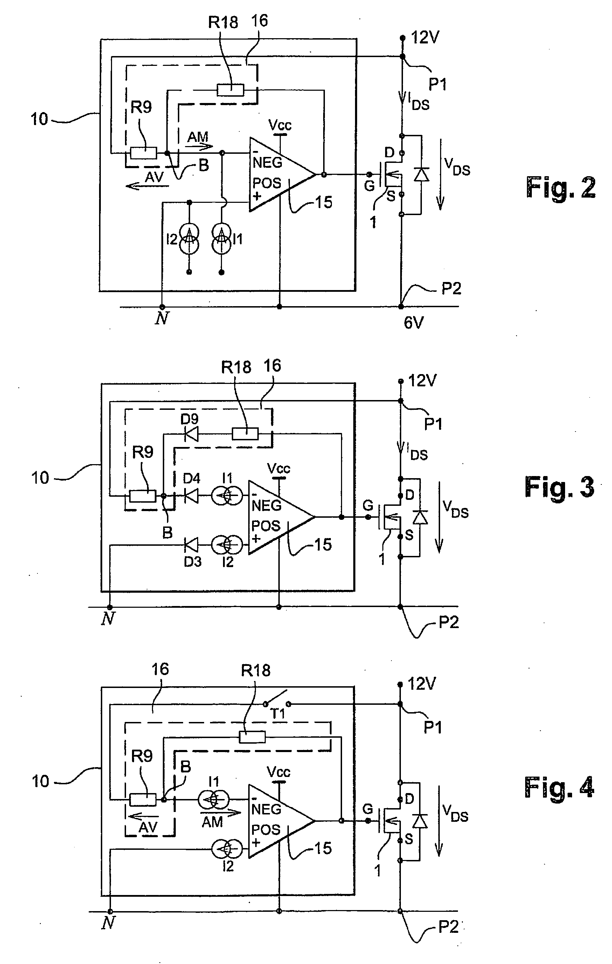

La Fig. 2 présente un premier exemple de schéma fonctionnel d'un dispositif de commande 10. Sur ce schéma, on peut voir que le dispositif de commande 10 comporte :
- un dispositif d'amplification 15 pour contrôler la grille G du transistor 1 via un signal de commande de sortie, ledit dispositif comprenant :
   ○ une première entrée NEG (-) couplée au drain D du transistor, via une première résistance R9, le tout formant une première liaison, et
   ○ une deuxième entrée POS (+) reliée à la source S du transistor, le tout formant une deuxième liaison,
- au moins un courant de polarisation I1 couplé à une des entrées, ici la première entrée NEG, ledit courant étant destiné à effectuer un décalage de la mesure de tension drain-source appelé tension de régulation Vr pour que le dispositif d'amplification fonctionne en régime linéaire avant d'ouvrir le transistor, et
- un dispositif de protection D contre les courants de fuite (non représenté sur cette Figure).

On notera que par abus de langage on parle de courant de polarisation. De façon précise, c'est une source d'alimentation permettant de polariser ledit dispositif de protection D par un courant.

Dans un mode de réalisation non limitatif, le dispositif de commande 10 comporte en outre une boucle de rétroaction 16 de la sortie du dispositif d'amplification 15 vers une de ses entrées, ici vers la première entrée NEG, ladite boucle comprenant une deuxième résistance R18. Cette boucle permet de maîtriser la fonction de transfert du dispositif d'amplification 15, notamment son gain, en réinjectant un courant de rétroaction. Par ailleurs, la résistance R18 permet une limitation dans le gain de ladite boucle en choisissant des valeurs données pour les résistances R18 et R9.

Dans un mode de réalisation non limitatif, la première entrée NEG du dispositif d'amplification 15 est l'entrée négative, et la deuxième entrée POS est l'entrée positive. Dans une variante, cela peut être l'inverse ; à ce moment la boucle de rétroaction 16 comporte un inverseur.

On notera que les courants de polarisation I1, I2 sont réalisés par exemple par une source de courant ou par une résistance reliée à un potentiel fixe. Par ailleurs, les courants de polarisation I1, I2 peuvent être intégrés dans le dispositif d'amplification 16, comme indiqué sur la Fig. 3. Ils vont ainsi servir également à l'amplification effectuée par le dispositif d'amplification 15. Ainsi, il n'est pas nécessaire d'ajouter un circuit externe. Ces courants de polarisation peuvent être différents. Dans le reste des Figures, les courants de polarisation I1 et I2 sont représentés intégrés. Mais ils peuvent bien entendu être externes.

La Fig. 3 montre un premier mode de réalisation d'un dispositif de protection D. Selon ce mode, un dispositif de protection D comporte au moins une diode placée sur une entrée du dispositif d'amplification 15.

Dans le cas où il n'existe pas de boucle de rétroaction 16, dans un mode de réalisation non limitatif, il existe une unique diode de protection D4 placée sur une des entrées du dispositif d'amplification 15, ici l'entrée négative NEG, en amont du point B (point reliant la première résistance R9 à la première entrée NEG du dispositif d'amplification 15).

Dans le cas où il existe une boucle de rétroaction, dans un mode de réalisation non limitatif, il existe en plus de la première diode D4 une deuxième diode D9 sur la boucle de rétroaction. La diode de rétroaction D9 permet de contrer une tension drain importante, ici 12V, et de contrer un courant de fuite provenant du drain et risquant de décharger la batterie.

On notera par ailleurs, qu'il existe, dans un mode de réalisation non limitatif, une troisième diode D3 sur l'entrée positive POS du dispositif d'amplification en vue d'égaliser les tensions entre les deux entrées. La troisième est choisie de manière à ce qu'elle ait les mêmes caractéristiques intrinsèques, comme la caractéristique tension-courant, en fonction de la température que la diode de protection D4. Elle peut soit être identique soit être différente mais avec les mêmes caractéristiques. Ceci permet la compensation d'une tension de décalage (décalage d'offset) générée par la diode protection D4, tension de décalage qui porterait préjudice à la mesure précise de la tension drain-source et donc à la maîtrise de la tension de régulation. En outre cette troisième diode D3 est parcourue par un autre courant de polarisation I2 couplé à la deuxième entrée, ici POS. Ainsi, on a une symétrie (même nombre de jonctions et composants de même nature) parfaite des jonctions semiconductrices sur les deux entrées POS et NEG.

Dans un premier mode de réalisation non limitatif, on choisit la valeur des courants de polarisation et les caractéristiques des diodes de telle sorte que les tensions aux bornes de ces diodes sont identiques. Ainsi, la tension de régulation Vr est constante en fonction de la température et est définie principalement par le premier courant de polarisation I1 qui traverse la première résistance R9. On peut par exemple prendre des courants de polarisation I1 et I2 identiques et constants pour toute tension d'alimentation du dispositif de commande, et les diodes D3 et D4 identiques. Ainsi, on supprime le décalage « offset » qui décalerait davantage la mesure en tension drain-source du transistor 5.

Dans un deuxième mode de réalisation non limitatif, on choisit la valeur des courants de polarisation et les caractéristiques des diodes de telle sorte que les tensions aux bornes de ces diodes sont différentes. Ainsi, la tension de régulation Vr est fonction de la température de manière croissante en valeur absolue et est définie principalement par le premier courant de polarisation I1 qui traverse la première résistance R9 et la diode D4 et par le deuxième courant de polarisation I2 qui traverse la diode D3. On peut par exemple prendre des courants de polarisation I1 et I2 différents et les diodes D3 et D4 identiques. Ce deuxième mode permet de conserver le régime de fonctionnement en mode linéaire avant l'ouverture du transistor 1 même à des températures élevées car le transistor MOS 1 a sa résistance interne qui augmente avec la température. En conséquence, on avance l'instant où on décharge la grille du transistor 1 par rapport au cas où la tension de régulation Vr est restée identique à celle de la basse température. Ainsi la grille du transistor 1 a le temps de se décharger correctement avant que le courant ne s'inverse dans le transistor 1. Ainsi, on limite les parasites électromagnétiques. On a ainsi cette fois un décalage « offset » maîtrisé qui varie en fonction de la température des diodes.

Ainsi, grâce aux diodes D3 et D4, et éventuellement aux courants de polarisation I1 et I2 associés (cas de la Figure 2 où les courants sont externes au dispositif d'amplification 15), on obtient un nombre N égal de jonctions semiconductrices entre les entrées drain et source du transistor et le premier étage du dispositif d'amplification 15. Donc, ici N = 1. Cela permet ainsi d'avoir une tension de régulation Vr très faible (de l'ordre de 40mV) par rapport à la tension d'une diode (de l'ordre de 0,7V). On a donc moins de pertes joules et donc un meilleur rendement de la machine. On notera que N peut être égal à 0 comme on le verra par la suite. On a toujours un nombre égal de jonctions.

De plus, en choisissant des composants de même nature sur les deux entrées (diode D4-diode D3 et courant I1-courant I2), on peut facilement les choisir avec les mêmes caractéristiques et donc obtenir une bonne symétrie sur les deux entrées. Cela permet de régler facilement la tension de régulation Vr, soit en fonction de la température (quand I1 différent de I2), soit à une valeur constante donnée (I1 égal I2).

En conséquence, grâce au nombre égal de jonctions semiconductrices et à cette symétrie, il est facile de choisir la tension de régulation Vr même avec une valeur très faible sans que des tensions de décalages provenant desdits composants choisis et générées par des dérives en température n'interviennent.

Par convention, l'amont du point B est représenté par la flèche AM et l'aval du point B par la flèche AV.

On notera que les deux premières diodes D4 et D9 sont placées là où il y a des courants de fuite lorsque le pont redresseur/onduleur est éteint à savoir :
- courant de fuite provenant de la batterie contré par la diode D9,
- courant de fuite provenant de la batterie contré par la diode D4.

Ce dispositif de protection D avec des diodes placées ainsi permet également de contrer les courants de fuite lorsque le pont redresseur/onduleur est allumé ou éteint.

Ainsi, la disposition de la Fig. 3 est un exemple non limitatif parmi d'autres.

Par exemple, on pourrait avoir les diodes D4, D3 directement connectées à la source et au drain du transistor 5 en aval du point B, tandis que la boucle de rétroaction 16 serait directement reliée au dispositif d'amplification 15 (non représenté).

On pourrait également remplacer les diodes par des transistors MOSFET. Lorsque le pont redresseur/onduleur serait arrêté, ces transistors seraient ouverts, tandis qu'allumé, ces transistors seraient au choix fermés ou allumés selon que respectivement l'on accepte ou non un courant de fuite.

La Fig. 4 montre un deuxième mode de réalisation d'un dispositif de protection D. Selon ce mode, le dispositif de protection D est un interrupteur T1 placé sur la première liaison du dispositif d'amplification 15, en aval du point B.

Ce transistor T1 est ouvert lorsque il ne circule pas de courant dans le pont redresseur/onduleur (véhicule à l'arrêt). Ainsi, aucun courant de fuite ne peut circuler de la batterie vers le dispositif d'amplification 15 et pont redresseur/onduleur. Le transistor T1 est fermé lorsqu'il existe un courant circulant dans le pont redresseur/onduleur (machine en mode alternateur ou en mode moteur).

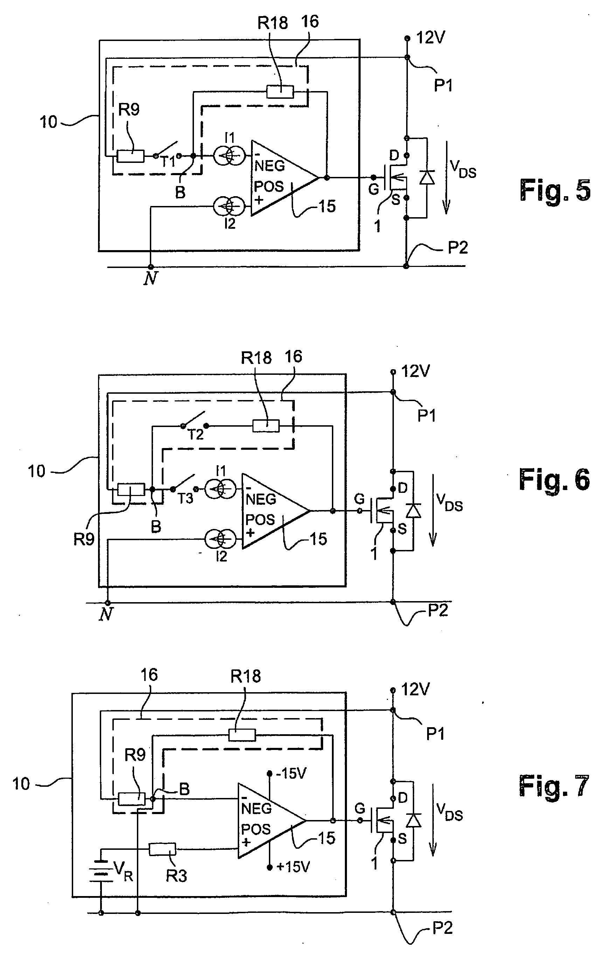

Dans une variante illustrée à la Fig. 5, le transistor de protection T1 est placé après la première résistance R9.

La Fig. 6 montre un troisième mode de réalisation d'un dispositif de protection D. Selon ce mode, le dispositif de protection D comporte un premier interrupteur T2 placé sur la boucle de réaction 16 du dispositif d'amplification 15 et un deuxième interrupteur T3 placé sur la première.

Ainsi, lorsqu'il existe un courant de fuite provenant de la batterie, on ouvre les deux interrupteurs T2 et T3, de sorte que le courant de fuite ne se disperse pas dans le dispositif d'amplification et pont redresseur/onduleur.

Dans une première variante, le deuxième interrupteur T3 est placé entre la première entrée NEG du dispositif d'amplification 15 et le point B, soit en amont dudit point B.

Dans une seconde variante, ledit deuxième interrupteur T3 est placé entre le point B et la résistance R9 de la première liaison, soit en aval dudit point B.

La Fig. 7 présente un deuxième exemple de schéma fonctionnel d'un dispositif de commande. Sur ce schéma, on peut voir que le dispositif de commande 10 comporte :
- un dispositif d'amplification I5 pour contrôler la grille G du transistor 1 via un signal de commande de sortie, ledit dispositif comprenant :
   ○ une première entrée NEG (-) couplée au drain D du transistor comprenant une première résistance R9, le tout formant une première liaison, et
   ○ une deuxième entrée POS (+) reliée à la source S du transistor, via une tension de régulation Vr, et comprenant une troisième résistance R3, le tout formant une deuxième liaison,
- une boucle de rétroaction 16 comprenant une deuxième résistance R18, et
- un dispositif de protection D (non représenté sur cette Figure) contre les courants de fuite.

On notera que dans ce mode, la tension de régulation est externe au dispositif d'amplification.

Par ailleurs, on notera que la résistance R3 permet d'avoir une même symétrie entre les entrées du transistor et le premier étage du dispositif d'amplification 15. Elle permet donc d'éviter les tensions de décalage entre la première liaison et la deuxième liaison et donc de ne pas biaiser la valeur de la tension de régulation externe Vr. Par ailleurs, cela facilite l'obtention d'une tension de régulation constante quand I1 = I2.

On notera que cette symétrie entre les résistances sur la première et la deuxième liaison peut être appliquée sur l'ensemble des modes de réalisation vues précédemment et vue ci-après.

Les modes de réalisation du dispositif de protection D sont les mêmes que dans le premier schéma fonctionnel du dispositif de commande 10.

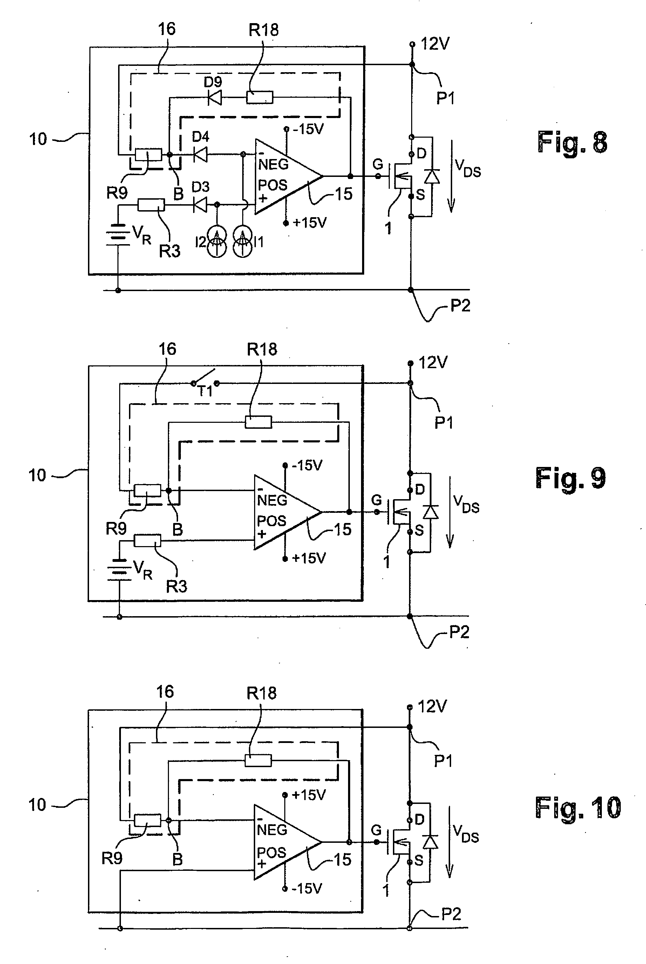

Ainsi, sur la Fig. 8, on peut voir les diodes de protection, tandis que sur la Fig. 9, on peut voir un premier interrupteur de protection T1 sur la première liaison. Les autres modes de réalisation des Fig. 5 et 6 vus dans le premier schéma fonctionnel sont également applicables mais non représentés sur des Figures.

On remarquera que ce dispositif de protection D appliqué à ce deuxième schéma fonctionnel permet d'annuler complètement les courants de fuite contrairement à d'autres solutions dans lequel le courant de fuite est permanent, par exemple dans le cas où on mettrait une diode de protection sur un fil reliant le point B à la source S du transistor 1. Par ailleurs, ces solutions présentées permettent d'obtenir un grand gain sans pour autant avoir une trop grande résistance R dans la boucle de rétroaction.

On notera que dans le cas où le dispositif de protection est réalisé avec un interrupteur, lorsque cet interrupteur est fermé, le nombre de jonctions dans la première et deuxième liaisons est nul. N = 0.

La Fig. 10 présente un troisième exemple de schéma fonctionnel d'un dispositif de commande. Sur ce schéma, on peut voir que le dispositif de commande 10 est le même que dans le premier schéma fonctionnel sauf concernant le dispositif d'amplification 15 qui est ici un composant standard alimenté en -15V, +15V.

Les modes de réalisation du dispositif de protection D sont les mêmes que dans le premier schéma fonctionnel du dispositif de commande 10.

On notera que pour les différents schémas fonctionnels présentés ci-dessus, dans le cas où un dispositif de commande 10 ne comporte pas de boucle de rétroaction, un seul dispositif de protection, diode ou interrupteur, est nécessaire.

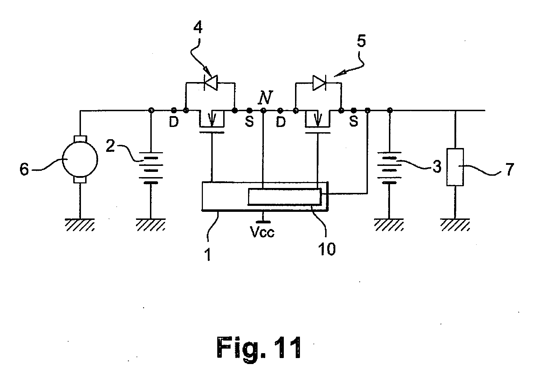

Le dispositif de commande 10 a été décrit selon l'application d'un pont de puissance. Cependant cette application n'est pas limitative. En effet, le dispositif de commande 10 d'un transistor peut également être mis en oeuvre dans un dispositif de charge de batterie illustré à la Fig. 11.

Dans cette application, comme illustré à la Fig. 11, une unité de contrôle 1 commande la charge de batteries 2 et 3 par l'intermédiaire de transistors MOS de puissance 4 et 5 dont les chemins de conduction sont disposés en série. La batterie 2 est par exemple connectée à un alternateur 6 ou démarreur ou encore alterno-démarreur, et la batterie 3 est connectée à un réseau de bord. La batterie 3 est connectée en parallèle avec la batterie 2 par l'intermédiaire des transistors 4 et 5, le transistor 4 étant disposé du côté de la batterie 2 et le transistor 5 étant disposé du côté de la batterie 3. Ces transistors sont commandés par l'unité de contrôle 1 comme des interrupteurs, par exemple sur la base d'un signal de commande externe. Les transistors 4 et 5 sont montés de sorte que leurs diodes parasites sont agencées avec leurs cathodes tournées respectivement vers la batterie 2 et vers la batterie 3. Ainsi, lorsque les deux transistors sont dans l'état bloqué (ouvert), aucun courant ne peut circuler d'une batterie vers l'autre. Cette unité de commande 1 comprend un dispositif de commande 10.

Le dispositif de commande 10 permet de commander le transistor 5 de manière autonome de sorte qu'il fonctionne comme une diode parfaite, tandis que le transistor 4 est commandé par un signal externe, en commande tout ou rien.

Le fonctionnement du dispositif de commande 10 est décrit ci-après. Il est décrit dans le cadre d'un fonctionnement d'un interrupteur reliant deux batteries. Ce fonctionnement est un exemple non limitatif.

### • Au niveau des batteries :

Dans une première étape INIT), dans un état initial, le système décrit à la Fig. 11 est au repos et aucun courant ne passe entre les deux batteries. Cette configuration correspond à un véhicule à l'arrêt sans aucun consommateur électrique.

Dans une deuxième étape +APC), quand l'utilisateur met la clé de contact, un courant (environ 20A) est consommé sur la batterie 3. Ce courant produit une chute de tension aux bornes de ladite batterie et le dispositif de commande 10 vient piloter le transistor 5 de façon à réduire la chute de tension.

Dans une troisième étape +DEM), lorsque l'utilisateur vient démarrer le moteur thermique par l'intermédiaire d'un démarreur ou d'un alterno-démarreur, le courant est prélevé sur la batterie 2. Ce courant important fait chuter la tension aux bornes de la batterie 2 de façon considérable (de 12V à 6V par exemple). Pour éviter que cette chute de tension ne vienne perturber le réseau de bord connecté à la batterie 3, il est souhaitable que le dispositif de commande 10 ouvre le transistor 5 rapidement. Une commande rapide permet aussi de protéger le transistor 5 contre un courant important qui pourrait le traverser.

Dans une quatrième étape ALT), lorsque le moteur thermique est démarré, l'alternateur 6 ou alterno-démarreur fournit du courant pour recharger les batteries 2 et 3, et le transistor 5 doit se fermer pour éviter les échauffements et pour maintenir les mêmes tensions de charge sur les deux batteries sans quoi la batterie 2 sera plus chargée que la batterie 3.

On notera que la boucle de rétroaction 16 intervient de la manière suivante pour les deuxième +APC et quatrième étapes ALT. Le courant de rétroaction, fonction de la tension grille Vg est réinjecté dans le dispositif d'amplification 15 de sorte que le gain du dispositif d'amplification 15 est limité, aux environs de 1000, améliorant ainsi la stabilité du dispositif de commande. Ainsi, lorsque la tension drain-source Vds est au voisinage de -30mV, on évite d'autant plus une commutation du transistor en tout ou rien (Vgrille-source = 0V ou Vcc) et donc d'éviter des oscillations. Ainsi, on fait varier le canal du transistor 5 en pilotant la tension grille-source Vgs en fonction des tensions Vds et Vgs (via la boucle de rétroaction 16).
Pour les première INIT et troisième +DEM étapes, le courant de rétroaction Iret est nul, la tension grille-source Vgs étant nul.

Ainsi, les dispositifs de protection présentés ci-dessus présentent les avantages suivants :
- Premièrement, lorsque le véhicule est à l'arrêt (contact coupé), par exemple sur un parking pendant un mois, cela permet au pont de puissance de l'alterno-démarreur de ne pas consommer de courant en permanence ; ainsi, cela évite une décharge potentielle de la batterie ;
- En effet, avec une ou plusieurs diodes de protection, comme on l'a vu précédemment, il n'existe aucun courant de fuite, que le pont de puissance soit éteint (véhicule à l'arrêt) ou qu'il soit allumé (véhicule entrain de rouler) ;
- Par ailleurs, avec un ou plusieurs interrupteurs, comme on l'a vu précédemment, il n'existe aucun courant de fuite lorsque le pont de puissance est éteint ; cependant il existe un courant de fuite lorsque le pont de puissance est allumé, ce qui n'a pas d'importance car à ce moment, le courant de fuite est négligeable par rapport au courant débité par le pont de puissance, soit d'environ 50A dans la première application décrite ;
- Deuxièmement, les dispositifs de protection présentés, diode ou interrupteur, permettent une protection contre les surtensions au point B présenté sur les différents schémas fonctionnels du dispositif de commande ;
- Troisièmement, dans le cas où il existe un condensateur de stabilité dans la boucle de rétroaction, ledit condensateur se déchargeant en général de 12V à 0,7V, une diode de protection permet une décharge rapide dudit condensateur quand son entrée (12V) change de signe ;
- Quatrièmement, le fait d'annuler les courants de fuite permet d'être en accord avec certaines normes constructeurs qui requièrent un courant de fuite total de 100micro-ampères ;
- Cinquièmement, le fait d'éviter les courants de fuite a pour autre avantage d'éviter une oxydation des phases du stator de l'alternateur dans le cas de l'application pont de puissance, l'alternateur étant dans un milieu souvent humide favorisant la corrosion. En effet, en cas de présence de courants de fuite, une différence de potentiel existe entre les phases et la carcasse de l'alternateur reliée à la masse du véhicule.
- Sixièmement, on peut voir que la réalisation du dispositif de commande est simple et donc facilement intégrable dans un circuit intégré ASIC ou directement sur le même substrat que le transistor de puissance MOS. On peut également mettre plusieurs dispositifs de commande sur le même substrat ou dans un même ASIC pour commander plusieurs transistors MOS. (par exemple un dispositif qui commande un bras de pont de puissance, ou encore l'ensemble des bras du pont etc...).

## Revendications

1. Combinaison d'un transistor de puissance de type MOSFET (1) et de son dispositif de commande (10),
ledit transistor de puissance (1) comprenant une grille (G), une source (S), et un drain (D),
ledit dispositif de commande (10) comprenant un amplificateur (15) ayant une première entrée négative (NEG), une deuxième entrée positive (POS) et une sortie, et comprenant également des premier (R9) et deuxième (R18) composants résistifs,
ledit amplificateur (15) commandant la grille (G) du transistor via un signal de commande de sortie délivré par ladite sortie de l'amplificateur, ladite première entrée négative (NEG) étant reliée audit drain (D) à travers au moins ledit premier composant résistif (R9), le tout formant ainsi une première liaison, ladite deuxième entrée positive (POS) étant reliée à ladite source (S) par une deuxième liaison et ledit deuxième composant résistif (R18) étant inclus dans une boucle de réaction entre ladite sortie de l'amplificateur et ladite première entrée négative (NEG), **caractérisé en ce que**
ledit dispositif de commande (10) comporte également des moyens d'empêchement de courant de fuite (D3, D4, D9) pour empêcher le passage d'un courant de fuite à travers ladite combinaison, ledit courant étant susceptible de décharger une source d'alimentation (BAT, 2, 3) à laquelle est reliée ladite combinaison, lesdits moyens comprenant au moins un premier (D3), un deuxième (D4) et un troisième (D9) élément semi-conducteur unidirectionnel insérés en série dans respectivement ladite première liaison, ladite deuxième liaison et ladite boucle de réaction, et le sens d'insertion de chacun desdits éléments semi-conducteurs unidirectionnels (D3, D4, D9) étant déterminé de manière à empêcher le passage dudit courant de fuite et le nombre desdits éléments semi-conducteurs unidirectionnels (D3, D4) insérés dans lesdites première et deuxième liaisons étant déterminés de manière à avoir un même nombre N de jonctions semi-conductrices dans lesdites première et deuxième liaisons.

2. Combinaison, selon la revendication 1, **caractérisée en ce que** les éléments semi-conducteurs unidirectionnels sont des diodes (D4, D9, D3).

3. Combinaison selon l'une des revendications précédentes, **caractérisée en ce que** le dispositif de commande (10) comprend des première (I1) et deuxième (I2) sources d'alimentation destinées à polariser lesdits premier (D3) et deuxième (D4) éléments semi-conducteurs unidirectionnels.

4. Combinaison selon l'une des revendications précédentes, **caractérisée en ce que** le dispositif de commande (10) est réalisé dans un circuit intégré (ASIC) comprenant ou non ledit transistor (5).

5. Combinaison selon l'une des revendications précédentes, 1 à 4, **caractérisée en que** ledit nombre N de jonctions semi-conductrices est égal à 1.

6. Système de gestion de deux batteries pour véhicule automobile, **caractérisé en ce qu'**il comporte une premier et une deuxième combinaisons (1, 4, 5, 10) selon l'une quelconque des revendications 1 à 5, lesdites combinaisons étant destinées à mettre en parallèle les batteries.

7. Pont de puissance pour machine électrique tournante polyphasée comprenant au moins un bras de pont composé de transistors de puissance de type MOSFET, le bras de pont étant associé à une phase de la machine, **caractérisé en ce qu'**il comporte, pour chaque transistor, un dispositif de commande (10) associé, lesdits transistors et dispositifs de commande formant des combinaisons selon l'une quelconque des revendications 1 a 5.

8. Machine électrique tournante comprenant un système de gestion de deux batteries selon la revendication 6.

9. Machine électrique tournante comprenant un pont de puissance selon la revendication 7.

## Claims

1. Combination of a power transistor of the MOSFET type (1) and its control device (10), the said power transistor (1) comprising a gate (G), a source (S) and a drain (D), the said control device (10) comprising an amplifier (15) which has a first, negative input (NEG), a second, positive input (POS) and an output, and also comprising first (R9) and second (R18) resistive components, the said amplifier (15) controlling the gate (G) of the transistor via an output control signal which is emitted by the said output of the amplifier, the said first, negative input (NEG) being connected to the said drain (D) by means of at least the said first resistive component (R9), the assembly thus forming a first connection, the said second, positive input (POS) being connected to the said source (S) by a second connection, and the said second resistive component (R18) being included in a reaction loop between the said output of the amplifier and the said first, negative input (NEG), **characterised in that** the said control device (10) also comprises means for prevention of leakage current (D3, D4, D9), in order to prevent the passage of a leakage current through the said combination, the said current being able to discharge a supply source (BAT, 2, 3) to which the said combination is connected, the said means comprising at least a first (D3), a second (D4) and a third (D9) one-way semiconductor elements which are inserted in series, respectively in the said first connection, the said second connection and the said reaction loop, and the direction of insertion of each of the said one-way semiconductor elements (D3, D4, D9) being determined such as to prevent the passage of the said leakage current, and the number of the said one-way semiconductor elements (D3, D4) inserted in the said first and second connections being determined such as to have the same number N of semiconductor junctions in the said first and second connections.

2. Combination according to claim 1, **characterised in that** the one-way semiconductor elements are diodes (D4, D9, D3).

3. Combination according to one of the preceding claims, **characterised in that** the control device (10) comprises first (I1) and second (I2) supply sources, which are designed to polarise the said first (D3) and second D4) one-way semiconductor elements.

4. Combination according to one of the preceding claims, **characterised in that** the control device (10) is provided in an integrated circuit (ASIC), which does or does not comprise the said transistor (5).

5. Combination according to one of the preceding claims 1 to 4, **characterised in that** the said number N of semiconductor junctions is equal to 1.

6. Control system for two batteries for a motor vehicle, **characterised in that** it comprises a first and a second combination (1, 4, 5, 10) according to any one of claims 1 to 5, the said combinations being designed to put the batteries in parallel.

7. Power bridge for a polyphase rotary electric machine comprising at least one bridge arm consisting of power transistors of the MOSFET type, the bridge arm being associated with a phase of the machine, **characterised in that** it comprises an associated control device (10) for each transistor, the said transistors and control devices forming combinations according to any one of claims 1 to 5.

8. Rotary electric machine comprising a control system according to claim 6, for two batteries.

9. Rotary electric machine comprising a power bridge according to claim 7.

## Patentansprüche

1. Kombination aus einem Leistungstransistor des Typs MOSFET (1) und seiner Steuervorrichtung (10),
wobei der besagte Leistungstransistor (1) ein Gate (G), eine Source (S) und einen Drain (D) umfasst,
wobei die besagte Steuervorrichtung (10) einen Verstärker (15) mit einem negativen ersten Eingang (NEG), einem positiven zweiten Eingang (POS) und einem Ausgang sowie außerdem erste (R9) und zweite (R18) Widerstandsbauelemente umfasst,
wobei der besagte Verstärker (15) das Gate (G) des Transistors über ein Ausgangssteuersignal steuert, das durch den besagten Ausgang des Verstärkers geliefert wird, und der besagte negative erste Eingang (NEG) wenigstens über das besagte erste Widerstandsbauelement (R9) mit dem besagten Drain (D) verbunden ist, so dass das Ganze eine erste Verbindung bildet, während der besagte positive zweite Eingang (POS) durch eine zweite Verbindung mit der besagten Source (S) verbunden ist, und das besagte zweite Widerstandsbauelement (R18) in einem Rückführungskreis zwischen dem besagten Ausgang des Verstärkers und dem besagten negativen ersten Eingang (NEG) enthalten ist, **dadurch gekennzeichnet, dass**
die besagte Steuervorrichtung (10) außerdem Mittel zur Leckstromvermeidung (D3, D4, D9) umfasst, um den Durchgang eines Leckstroms durch die besagte Kombination zu verhindern, wobei der besagte Strom eine Versorgungsspannung (BAT, 2, 3) entladen könnte, an die die besagte Kombination angeschlossen ist, wobei die besagten Mittel mindestens ein erstes (D3), ein zweites (D4) und ein drittes (D9) unidirektionales Halbleiterelement umfassen, die in der besagten ersten Verbindung, der besagten zweiten Verbindung bzw. dem besagten Rückführungskreis in Reihe eingesetzt sind, und wobei die Einsetzrichtung jedes dieser unidirektionalen Halbleiterelemente (D3, D4, D9) so bestimmt ist, dass der Durchgang des besagten Leckstroms verhindert wird, und wobei die Anzahl der besagten in die besagten ersten und zweiten Verbindungen eingesetzten unidirektionalen Halbleiterelemente (D3, D4) so bestimmt ist, dass sich eine gleiche Anzahl N von Halbleiterübergängen in den besagten ersten und zweiten Verbindungen ergibt.

2. Kombination nach Anspruch 1, **dadurch gekennzeichnet, das** die unidirektionalen Halbleiterelemente Dioden (D4, D9, D3) sind.

3. Kombination nach einem der vorangehenden Ansprüche, **dadurch gekennzeichnet, dass** die Steuervorrichtung (10) erste (I1) und zweite (I2) Versorgungsquellen umfasst, die dazu bestimmt sind, die besagten ersten (D3) und zweiten (D4) unidirektionalen Halbleiterelemente vorzuspannen,

4. Kombination nach einem der vorangehenden Ansprüche, **da** - **durch gekennzeichnet, dass** die Steuervorrichtung (10) in einer integrierten Schaltung (ASIC) ausgeführt ist, die den besagten Transistor (5) umfasst oder nicht.

5. Kombination nach einem der vorangehenden Ansprüche 1 bis 4, **dadurch gekennzeichnet, dass** die besagte Anzahl N von Halbleiterübergängen gleich 1 ist.

6. System zur Regelung von zwei Batterien für Kraftfahrzeuge, **dadurch gekennzeichnet, dass** es eine erste und eine zweite Kombination (1, 4, 5, 10) nach einem der Ansprüche 1 bis 5 umfasst, wobei die besagten Kombinationen dazu bestimmt sind, die Batterien parallel zu schalten.

7. Leistungsbrücke für eine mehrphasige rotierende elektrische Maschine, die mindestens einen Brückenzweig umfasst, der aus Leistungstransistoren des Typs MOSFET besteht, wobei der Brückenzweig einer Phase der Maschine zugeordnet ist, **dadurch gekennzeichnet, dass** sie für jeden Transistor eine zugehörige Steuervorrichtung (10) umfasst, wobei die besagten Transistoren und Steuervorrichtungen Kombinationen nach einem der Ansprüche 1 bis 5 bilden.

8. Rotierende elektrische Maschine, die ein System zur Regelung von zwei Batterien nach Anspruch 6 umfasst.

9. Rotierende elektrische Maschine, die eine Leistungsbrücke nach Anspruch 7 umfasst.
